# EUROPEAN PATENT APPLICATION

(11) **EP 1 257 025 A2**
(43) Date of publication of application: **13.11.2002**
(21) Application number: 02008568.4
(22) Date of filing: 16.04.2002
(51) Int. Cl.: H01S 5/183

(54) **Surface emitting semiconductor laser device**

(30) Priority: 18.04.2001 JP 2001119715; 21.12.2001 JP 2001389040
(71) Applicant: THE FURUKAWA ELECTRIC CO., LTD., Tokyo (JP)
(72) Inventor: Shinagawa, Tatsuyuki, 2-chome, Chiyoda-ku, Tokyo (JP); Yokouchi, Noriyuki, 2-chome, Chiyoda-ku, Tokyo (JP); Shina, Yasukazu, 2-chome, Chiyoda-ku, Tokyo (JP); Kasukawa, Akihiko, 2-chome, Chiyoda-ku, Tokyo (JP)
(74) Representative: Pätzold, Herbert, Dr.-Ing.

(57) **Abstract**

A surface emission semiconductor laser device includes a GaAs substrate and a layer structure having a plurality of constituent layers including an active layer, a pair of cladding layers, and a pair of multilayer semiconductor mirrors. One of the multilayer mirrors includes an AlAs layer having an Al-oxidized area forming a current confinement structure. At least one of the constituent layers, such as active layer or one of the multilayer mirrors, has an oxygen density of 1 × 10¹⁸ cm₋₃ or less. The laser device suppresses reduction of the optical output power with time.

## Description

### BACKGROUND OF THE INVENTION

### (a) Field of the Invention

The present invention relates to a surface emitting semiconductor laser device and, more particularly, to a surface emitting semiconductor laser device having a higher reliability and especially suited for use in an optical data transmission and an optical communication.

### (b) Description of the Related Art

A surface emission semiconductor laser device (simply referred to as a surface emission laser device, hereinafter) is generally used for emitting a laser beam in the direction perpendicular to the substrate surface of the laser device. It is possible to arrange a plurality of surface emission laser devices on a single substrate to form a two-dimensional array, and due to this advantage over the conventional Fabry-Perot laser device, the surface emission laser device now attracts higher attentions in the field of data transmission.

The surface emission laser device has a structure wherein a pair of semiconductor multilayer mirrors made of AlGaAs/GaAs layers overlie a GaAs or InP substrate to sandwich therebetween a laser active layer having an emission area. There are some proposals as to the current confinement structure using an oxidation technique for raising the current injection efficiency to reduce the threshold current for laser emission.

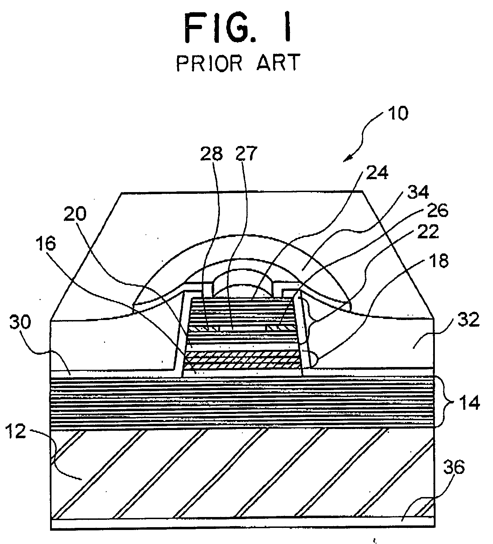

Fig. 1 shows a typical surface emission laser device having a selectively-oxidized current confinement structure. The laser device includes an n-type GaAs substrate (n-GaAs substrate) 12, and a layer structure formed thereon. The layer structure includes a lower multilayer mirror 14 including 30.5 pairs of n-type AlGaAs/AlGaAs layers, an AlGaAs lower cladding layer 16, a GaAs/AlGaAs multiple-quantum-well (MQW) active layer structure 18, an AlGaAs upper cladding layer 20, an upper multilayer mirror 22 including 25 pairs of p-type AlGaAs/AlGaAs layers, and a GaAs cap layer 24 consecutively formed on the n-GaAs substrate 12.

For achieving an efficient confinement structure for the injected current, an AlAs layer 26 is disposed instead of one of the AlGaAs layers of the upper multilayer mirror 22 near the active layer structure 18, the AlAs layer 26 having a central non-oxidized area 27 and a peripheral oxidized-Al area 28 wherein the Al content of the AlAs layer 26 is selectively oxidized to have a higher electric resistance.

The lower cladding layer 16, active layer structure 18, upper cladding layer 20, upper multilayer mirror 22 including the AlAs layer 26, and the cap layer 24 are configured to have a mesa structure. A protective layer 30 made of silicon oxide or silicon nitride is formed on the entire top surface of the mesa structure except for a window area which exposes therefrom the cap layer 24. A polyimide layer 32 is formed on the protective layer 30 at both the sides of the mesa structure, the polyimide layer 30 having a function for reducing the parasitic capacitance of the laser device. A p-side electrode 34 is formed on the cap layer 24 exposed from the window area, whereas an n-side electrode 36 is formed on the bottom surface of the GaAs substrate 12.

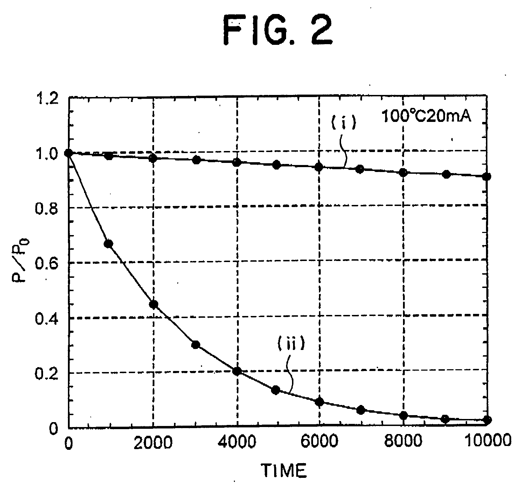

Fig. 2 includes graph (ii) showing a time chart for the optical output power of a conventional surface emission laser device having the structure of Fig. 1, wherein the optical output power reduces with the operating time irrespective of the injection current being maintained at a constant. In Fig. 2, the ratio of the optical output power (P) to the initial optical output power (P₀) calculated at each time instant is plotted on ordinate against the operating time length plotted on the abscissa. The reliability of the conventional surface emission laser device is degraded by this characteristic of the optical output power, which limits applications of the surface emission laser device.

### SUMMARY OF THE INVENTION

In view of the above, it is an object of the present invention to provide a surface emission laser device which is capable of suppressing reduction of the optical output power with time and thus has a higher operational reliability.

The present invention provides a semiconductor laser including a plurality of epitaxial layers, wherein at least one of the plurality of layers has an oxygen density of less than or equal to about 1 x 10¹⁸ cm⁻³.

In accordance with the semiconductor laser of the present invention, the lower oxygen density in the at least one of the plurality of layers provides reduction of the point defects and the crystal dislocations in the semiconductor laser, whereby reduction of the optical output power of the semiconductor laser with time can be suppressed and a higher reliability can be achieved.

The above and other objects, features and advantages of the present invention will be more apparent from the following description, referring to the accompanying drawings.

### BRIEF DESCRIPTION OF THE DRAWINGS

Fig. 1 is a sectional view of a typical surface emission laser device.
Fig. 2 is a time chart showing optical output powers of the conventional surface emission laser device and the surface emission laser according to an embodiment of the present invention.
Fig. 3 is a sectional view of the layer structure of a surface emission laser device according to a first embodiment of the present invention.
Fig. 4 is a time chart showing the growth temperature in the growth process, and the ratios of the number of V-group atoms to the number of III-group atoms in the source gas during the growth process.
Fig. 5 is a graph showing the oxygen density plotted against the depth of the lower multilayer mirror in the surface emission laser device of the embodiment.
Fig. 6 is a graph showing the oxygen density plotted against the depth of the lower multilayer mirror in the conventional surface emission laser device.
Fig. 7 is a graph showing the spectrums of the photoluminescence obtained by epitaxial crystals of the laser device of the embodiment and the conventional laser device after removal of the upper multilayer mirror.
Fig. 8 is a sectional view of the layer structure of a surface emission laser device according to a second embodiment of the present invention.

### PREFERRED EMBODIMENT OF THE INVENTION

Before describing embodiments of the present invention, the principle of the present invention will be described hereinafter for a better understanding of the present invention.

It is noted by the present inventor that an end emission laser device generally suffers from a catastrophic optical damage (COD) phenomenon and a dark line defect (DLD) phenomenon, which degrade the characteristics of the end emission laser device. The COD phenomenon is such that the reflection end of the laser device is degraded due to the crystal dislocations caused by an excessive temperature rise, which involves a local meltdown of the reflection end. The DLD phenomenon is caused by growth of the crystal dislocations which eventually assume a structure of a dislocation net, whereby the emission area exhibits a linear non-emission region observed as a dark line.

On the other hand, the surface emission laser device generally suffers from a different degradation, wherein generation of a loop of crystal dislocations in a sectional area of the laser device is observed by a transmission electron microscopy (TEM). Thus, the degradation is considered to result from the point defects or the assembly thereof, i.e., crystal dislocation.

The selectively-oxidized current confinement structure as described above involves reduction of the volume of the AlAs layer by around 30 to 40 percents, thereby generating a higher stress in the AlAs layer to cause the crystal dislocations. This is also considered one of the factors for the degradation of the surface emission laser device.

For suppressing the degradation of the surface emission laser device caused by the crystal dislocations to improve the reliability thereof, it is considered to replace the conventional AlAs layer with an Al_{0.98}Ga_{0.02}As layer, which generally involves lower reduction of the volume during oxidation thereof and thus is considered to suppress the growth of the dislocations.

It is to be noted, however, that the Al_{0.98}Ga_{0.0}2As layer itself cannot afford reduction of the density of the point defects or dislocations which cause the degradation, although adoption of the Al_{0.98}Ga_{0.02}As layer reduces the degradation rate or speed.

The present inventor conceived that the oxygen atoms within the constituent layers of the surface emission laser device might cause the point defects and the crystal dislocations, and that reduction of the oxygen concentration in the constituent layers could reduce the density of the point defects and dislocations. A number of experiments conducted along with this conception resulted in the findings as detailed hereinafter.

The first finding is that a lower density of oxygen atoms, as low as 1 × 10¹⁸ cm⁻³ or lower, in at least one of the constituent layers of the surface emission laser device suppresses reduction of the optical output power of the laser device as described before. The oxygen atoms to be counted here include separated oxygen atoms, and coupled oxygen atoms which exist in a compound or compounds of oxygen with another substance or other substances and in a complex or complexes of oxygen coupled with an inherent defect. The term "compound of oxygen with another substance or other substances" as used herein, which may be referred to as oxygen compound hereinafter, means a specific compound wherein oxygen is coupled with impurity atoms in the crystal, whereas the term "complex of oxygen with an inherent defect" as used herein, which may be referred to as oxygen complex hereinafter, means a specific complex wherein oxygen is coupled with an inherent defect formed in the crystal of the constituent layer including Al, Ga and As atoms. The types of inherent defect assume a substituted atom, an atomic hole and an interstitial atom in the crystal structure of the constituent layer.

The second finding is that the lower density of oxygen atoms as low as 1 × 10¹⁸ cm⁻³ or lower can be obtained by:
growing the crystal structure of the constituent layers, such as active layer structure, cladding layer and/or multilayer mirrors, at a temperature of 700 degrees C or higher;
adopting a higher atomic ratio of V-group element to III-group element (referred to as V/III ratio hereinafter), for example, a V/III ratio of 80 in the source gas used for growing the lower multilayer mirror, active layer structure and cladding layer and a V/III ratio of 20 in the source gas used for growing the upper multilayer mirror; and/or
reducing the number of oxygen atoms caught or incorporated in the crystal structure by adopting, for example, trymethyl-aluminum source gas including a lower oxygen concentration, for example, lower than 2ppm for oxygen concentration.

The at least one of the constituent layers may be the active layer structure, the layers residing in an area of the resonant cavity corresponding to the equivalent cavity length, the n-type multilayer mirror and/or the p-type multilayer mirror. The term "resonant cavity corresponding to the equivalent cavity length" as used herein in the surface emitting laser device resides between the five pairs of layers of the upper multilayer mirror near the active layer and the five pairs of layers of the lower multilayer mirror near the active layer, inclusive of both the five pairs.

It is to be noted that all the constituent layers need not have a lower oxygen density, and it is sufficient that at least one of the constituent layers has a lower oxygen density as low as 1 × 10¹⁸ cm⁻³ or lower. The lower oxygen density provides a stable operation of surface emission laser device for a long time and a higher efficiency for the electric-optical conversion.

Among other constituent layers, the lower multilayer mirror provides a remarkable effect by having the lower oxygen density, and a larger number of constituent layers having the lower oxygen density provides a higher effect.

It is more preferable that at least one of the constituent layers of the surface emission laser device have a further lower oxygen density as low as 1 × 10¹⁷cm⁻³ or lower.

Now, the present invention is more specifically described with reference to the preferred embodiments thereof.

In one specific embodiment that has been manufactured and tested, a surface emission laser device includes constituent layers similar to the constituent layers of the conventional laser device of Fig. 1 except that each of the constituent layers in the specific embodiment has an oxygen density as low as 1 × 10¹⁷ cm⁻³ or lower

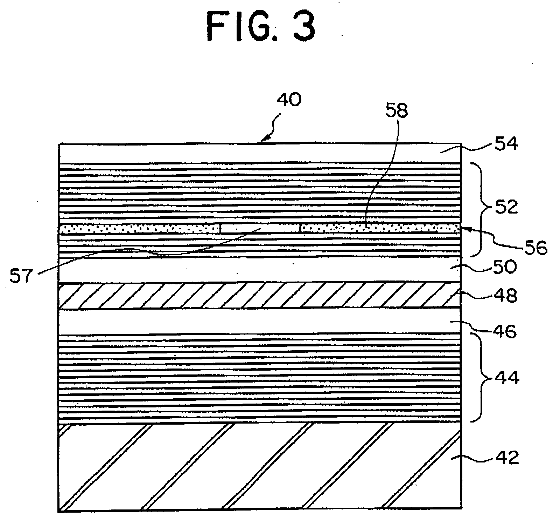

Referring to Fig. 3, the surface emission laser device of the present embodiment, generally designated by numeral 40, includes an n-GaAs substrate 42 and a layer structure formed thereon. The layer structure has constituent layers including consecutively, as viewed from the bottom, an n-type lower multilayer mirror 44, an Al_{0.3}Ga_{0.7}As lower cladding layer 46, an active layer structure 48, an Al_{0.3}Ga_{0.7}As upper cladding layer 50, a p-type upper multilayer mirror 52, and a p-GaAs cap layer 54.

The lower multilayer mirror 44 includes 30.5 pairs of n-type Al_{0.2}Ga_{0.8}As/Al_{0.9}Ga_{0.1}As layers.

The active layer structure 48 is implemented as a GaAs/Al_{0.2}Ga_{0.8}As MQW structure including three 7-nm-thick GaAs quantum well (QW) layers for laser emission.

The upper multilayer mirror 52 includes 25 pairs of Al_{0.2}Ga_{0.8}As/Al_{0.9}Ga_{0.1}As layers, wherein one of the Al_{0.9}Ga_{0.1}As layers near the active layer structure 48 is replaced by an AlAs layer 56. The AlAs layer 56 has a current injection area 57 at the center thereof for injecting current to the active layer structure 48, and a selectively oxidized area 58 wherein the Al content of the AlAs layer 56 is selectively oxidized.

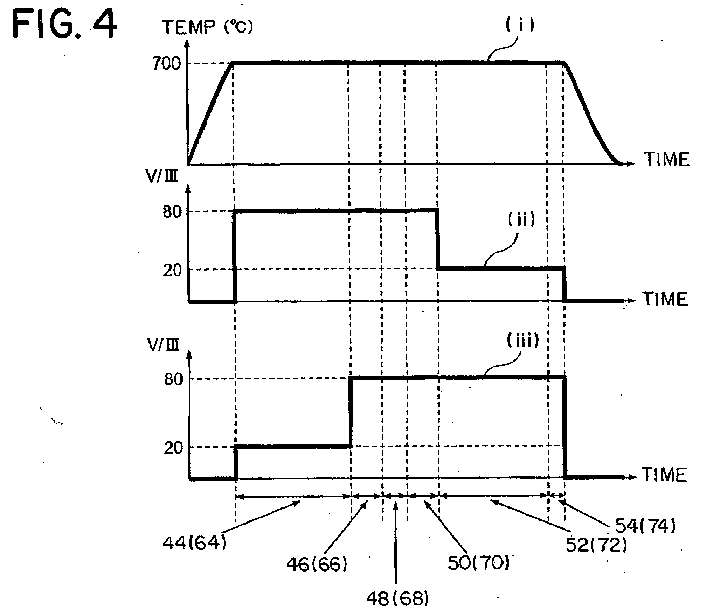

Referring to Fig. 4, there is shown a growth temperature profile at curve (i) as well as a V/III ratio profile in the source gas at curve (ii) during the epitaxial growth process of the constituent layers of the surface emission laser device of the present embodiment.

First, 30.5 pairs of n-type Al_{0.2}Ga_{0.8}As/Al_{0.9}Ga_{0.1}As layers are grown on the GaAs substrate 42 at a temperature of 700 degrees C by a metal-organic chemical vapor deposition (MOCVD) using a source gas having a V/III ratio of 80, based on curves (i) and (ii).

Subsequently, the Al_{0.3}Ga_{0.7}As lower cladding layer 46, the GaAs/Al_{0.2}Ga_{0.8}As MQW active layer structure 48 including three 7-nm-thick QW layers, and the Al_{0.3}Ga_{0.7}As upper cladding layer 50 are grown at a temperature of 700 degrees C by using a source gas having a V/III ratio of 80 based on curves (i) and (ii).

Thereafter, the upper multilayer mirror 52 including 25 pairs of p-type Al_{0.2}Ga_{0.8}As/Al_{0.9}Ga_{0.1}As layers are grown, followed by growing the p-type GaAs cap layer 54 on the topmost Al_{0.2}Ga_{0.8}As layer, both at a temperature of 700 degrees C and using source gases having a V/III ratio of 20 based on curves (i) and (ii). In this step, one of the Al_{0.9}Ga_{0.1}As layers of the n-type multilayer mirror 52 is replaced by the AlAs layer 56.

Subsequently, the AlAs layer 56 is selectively oxidized to form the selectively-oxidized current confinement structure in the AlAs layer 56.

For reduction of the oxygen atoms incorporated in the crystal structure, trymethyl-aluminum having a lower oxygen density, lower than 2ppm for example, is used as one of the source gases.

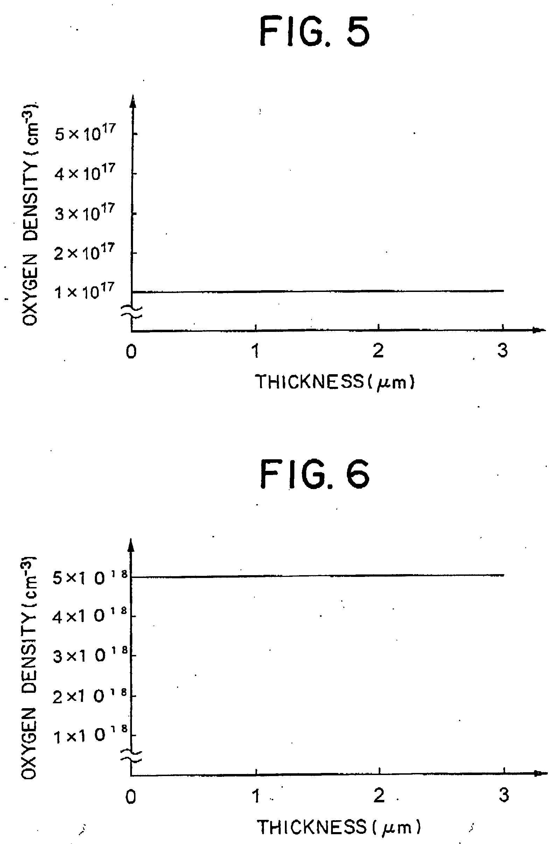

The oxygen density of the constituent layers formed by the above process was evaluated by using a secondary ion mass spectroscopy (SIMS). The result of evaluation for the lower multilayer mirror is shown in Fig. 5, exhibiting a remarkably lower oxygen density in the present embodiment compared to the oxygen density measured in the conventional laser device, which is shown in Fig. 6 for a comparison purpose. In Figs. 5 and 6, the oxygen density is plotted against the location in the thickness direction of the mirror.

More specifically, the lower multilayer mirror in the conventional laser device had an oxygen density of 5×10¹⁸ cm⁻³, whereas the lower multilayer mirror in the laser device of the present embodiment had an oxygen density of 1 × 10¹⁷ cm⁻³, exhibiting a remarkable reduction of the oxygen density in the lower multilayer mirror.

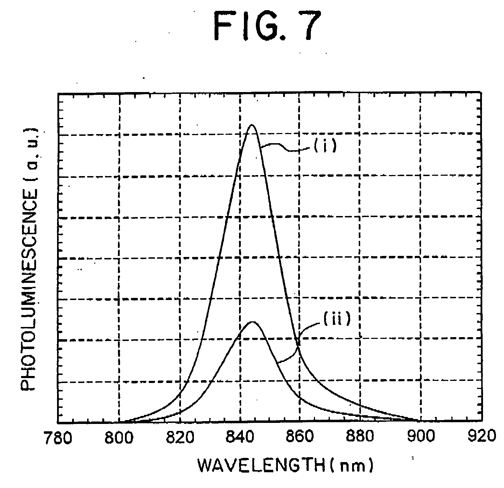

A sample of surface emission laser device of the present embodiment was manufactured, and after removing the upper multilayer mirror by etching, the sample is subjected to measurement of photoluminescence for evaluation of the emission characteristic with respect to the emission wavelength. The results are shown at graph (i) in Fig. 7 compared to graph (ii) showing the photoluminescence of the conventional surface emission laser device.

As understood from the graphs, by adopting a source gas having a higher V/III ratio and a lower oxygen concentration, the laser device of the present embodiment achieves a higher emission efficiency due to reduction of the oxygen density in the crystal structure and a resultant improvement of the crystallinity.

The surface emission laser device manufactured by the method of the present embodiment and the conventional surface emission laser device were subjected to energizing tests at an operating temperature of 100 degrees C and an operating current of 20 mA. The results of the operation of the laser device of the present embodiment are shown at graph (i) in Fig. 2, compared to graph (ii) of the conventional laser device.

As understood from Fig. 2, the surface emission laser device of the present embodiment can suppress the reduction in the optical output power with respect to the operating time and thus has a significant advantage over the conventional laser device. It was confirmed that the laser device of the present embodiment operated at a stable condition for 100,000 hours at the room temperature.

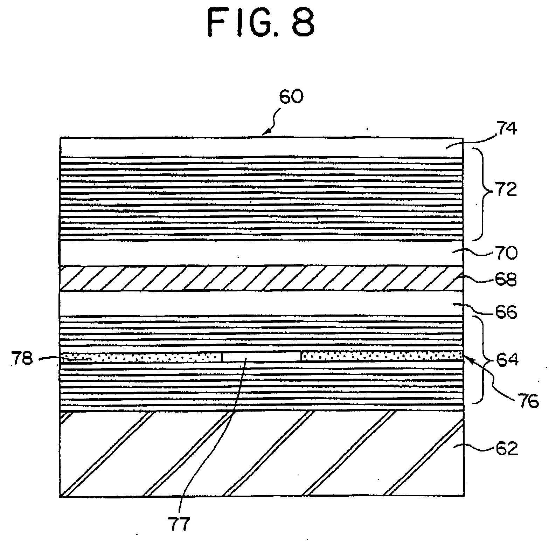

Referring to Fig. 8, a surface emission laser device, generally designated by numeral 60, according to a second embodiment of the present invention includes a p-GaAs substrate 62 and a layer structure formed thereon. The layer structure includes consecutively, as viewed from the bottom, a p-type lower multilayer mirror 64, an Al_{0.3}Ga_{0.7}As lower cladding layer 66, an active layer structure 68, an Al_{0.3}Ga_{0.7}As upper cladding layer 70, an n-type upper multilayer mirror 72, and an n-GaAs cap layer 74. Among the constituent layers of the layer structure, the upper multilayer mirror 72 has an oxygen density of 1 × 10¹⁷ cm⁻³ or less.

The lower multilayer mirror 64 includes 30.5 pairs of Al_{0.2}Ga_{0.8}As/Al_{0.9}Ga_{0.1}As layers, wherein an AlAs layer 76 replaces one of the Al_{0.9}Ga_{0.1}As layer of the lower multilayer mirror 64 near the active layer structure 68. The AlAs layer 76 has a current injection area 77 and a selectively-oxidized area 78 wherein the Al content of the AlAs layer 76 is selectively oxidized. The active layer structure 68 is implemented as a GaAs/Al_{0.2}Ga_{0.8}As MQW structure including three 7-nm-thick GaAs QW layers. The upper multilayer mirror 72 includes 25 pairs of n-type Al_{0.2}Ga_{0.8}As/Al_{0.9}Ga_{0.1}As layers..

The surface emission laser device of Fig. 8 is manufactured by the process as detailed below. The process adopts a growth temperature profile shown at curve (i) and a source gas having a V/III ratio profile shown at curve (iii), both in Fig. 4. First, the lower multilayer mirror 64 including 30.5 pairs of p-type Al_{0.2}Ga_{0.8}As/Al_{0.9}Ga_{0.1}As layers is epitaxially grown on the p-GaAs substrate 62 at a temperature of 700 degrees C by a MOCVD technique using a source gas having a V/III ratio of 20. One of the Al_{0.9}Ga_{0.1}As layers of the lower multilayer mirror 64 is replaced by an AlAs layer 76 having a selectively-oxidized current confinement structure after the heat treatment.

Subsequently, the undoped Al_{0.3}Ga_{0.7}As lower cladding layer 66, the GaAs/Al_{0.2}Ga_{0.8}As MQW active layer structure 68 including three 7-nm-thick QW layers as emission layers, and the n-Al_{0.3}Ga_{0.7}As upper cladding layer 70 are epitaxially grown at a temperature of 700 degrees C by using source gases each having a V/III ratio of 80.

Thereafter, the upper multilayer mirror 72 including 25 pairs of n-type Al_{0.2}Ga_{0.8}As/Al_{0.9}Ga_{0.1}As layers is grown, followed by deposition of the n-GaAs cap layer 74 the top Al_{0.2}Ga_{0.8}As layer of the upper multilayer mirror 72, both at a temperature of 700 degrees C by a MOCVD technique using source gases each having a V/III ratio of 80.

A sample of the surface emission laser device according to the present embodiment was manufactured and subjected to a SIMS measurement with respect to the oxygen density of the constituent layers. The results were similar to those observed for the first embodiment and shown in Fig. 5, exhibiting a remarkable reduction of the oxygen density.

The upper multilayer mirror 72 in the sample was removed by etching and the sample was then subjected to measurement of photoluminescence, the results of which were similar to those shown by graph (i) in Fig. 7. Another sample manufactured according to the present embodiment was subjected to an energizing test at an operating temperature of 100 degrees C and an operating current of 20 mA, the results of which were similar to those shown at graph (i) in Fig. 2.

Since the above embodiments are described only for examples, the present invention is not limited to the above embodiments and various modifications or alterations can be easily made therefrom by those skilled in the art without departing from the scope of the present invention. For example, the active layer structure may be a single active layer or a single-quantum-well layer.

## Claims

1. A semiconductor laser comprising a plurality of epitaxial layers, wherein at least one of said plurality of layers has an oxygen density of less than or equal to about 1 x 10¹⁸ cm⁻³.

2. The semiconductor laser of Claim 1, wherein at least one of said plurality of layers has an oxygen density of less than or equal to about 1 x 10¹⁷ cm⁻³.

3. The semiconductor laser of Claim 1, wherein said plurality of layers comprises an upper mirror, an upper cladding layer, an active layer, a lower cladding layer, and a lower mirror, wherein said lower mirror has an oxygen density of less than or equal to about 1 x 10¹⁸ cm⁻³.

4. The semiconductor laser of Claim 1, wherein said plurality of layers comprises an upper mirror (52), an upper cladding layer (50), an active layer (48), a lower cladding layer (46), and a lower mirror (44), wherein said upper mirror (52) has an oxygen density of less than or equal to about 1 x 10¹⁸ cm⁻³.

5. The semiconductor laser of Claim 1, wherein said plurality of layers comprises an upper mirror (52), an upper cladding layer (50), an active layer (48), a lower cladding layer (46), and a lower mirror (44), wherein said active layer (48) has an oxygen density of less than or equal to about 1 x 10¹⁸ cm⁻³.

6. The semiconductor laser of Claim 1, wherein said plurality of layers comprises an upper mirror (52), an upper cladding layer (50), an active layer (48), a lower cladding layer (46), and a lower mirror (44), wherein said upper cladding layer (50) has an oxygen density of less than or equal to about 1 x 10¹⁸ cm⁻³.

7. The semiconductor laser of Claim 1, wherein said plurality of layers comprises an upper mirror (52), an upper cladding layer (50), an active layer (48), a lower cladding layer (46), and a lower mirror (44), wherein said lower cladding layer (46) has an oxygen density of less than or equal to about 1 x 10¹⁸ cm⁻³.

8. A method of substantially maintaining an optical output power from a surface emission laser device over time, the method comprising:
forming a multilayer mirror (52, 44) including at least one AlₓGa₁₋ₓAs layer, where 0≤ x≤ 1; said multilayer mirror (52, 44) having an oxygen density of less than or equal to about 1 x 10¹⁸ cm⁻³.

9. The method of Claim 6, wherein said multilayer mirror (52, 44) includes at least one Al_{y}Ga_{1-y}As layer, where 0≤ y≤ 1 and x ≠ y.

10. The method of Claim 6, wherein said multilayer mirror (52, 44) has an oxygen density of less than or equal to about 1 x 10¹⁷ cm⁻³.

11. A method of forming a semiconductor laser having a plurality of layers including an upper mirror (52), an upper cladding layer (50), an active layer, a lower cladding layer (46), and a lower mirror (4), the method comprising:
growing said plurality of layers at a temperature of 700 degrees;
injecting a source gas onto said semiconductor laser during said act of growing said lower mirror (44), said active layer (48), and said upper cladding layer (50),
wherein a ratio of said group V elements to group III elements in said source gas is about 80;
injecting a second source gas onto said semiconductor laser during said act of growing said upper mirror (52),
wherein a second ratio of group V elements to group III elements in said second source gas is about 20.

12. The method of Claim 11, wherein said source gas comprises triethyl-alminum and/or trimethyl-aluminum.

13. The method of Claim 12, wherein said triethyl-alminum and/or trimethyl-aluminum has an oxygen content of less than or equal to about 2ppm.

14. The method of Claim 11, wherein at least one of said plurality of layers has an oxygen density of less than or equal to about 1 x 10¹⁷ cm⁻³.

15. A semiconductor laser made by the method of Claim 11.

16. A method of forming a multi-layer semiconductor laser device including a GaAs substrate, comprising:
growing on said GaAs substrate (42) a lower multilayer mirror (44), a lower cladding layer (46), an active layer structure (48), an upper cladding layer (50), and an upper multilayer mirror (52);
wherein said acts of growing said lower multilayer mirror (44), said lower cladding layer (46), said active layer structure (48), and said upper cladding layer (50) are performed at a temperature of about 700 degrees C utilizing a source gas having a ratio of group V elements to group III elements of about 80.

17. The method of Claim 16, further comprising:
growing on said an upper multilayer mirror (52) a cap layer (54) at a temperature of about 700 degrees C utilizing a source gas having a ratio of group V elements to group III elements of about 20.

18. The method of Claim 17, further comprising:
growing on said upper multilayer mirror (52) a cap layer (54) at a temperature of about 700 degrees C utilizing a source gas having a ratio of group V elements to group III elements of about 20.

19. The method of Claim 17, wherein said lower multilayer mirror (44) has an oxygen density of less than or equal to about 1 x 10¹⁸ cm⁻³.

20. The method of Claim 16, wherein said lower multilayer mirror (44) comprises a plurality of n-type Al_{0.2}Ga_{0.8}As/Al_{0.9}Ga_{0.1}As layers.

21. The method of Claim 16, wherein said lower cladding layer (46) and said upper cladding layer (50) comprise Al_{0.3}Ga_{0.7}As.

22. The method of Claim 16, wherein said active layer structure (48) comprises at least three QW layers.

23. The method of Claim 17, wherein said upper multilayer mirror (52) comprises a plurality of p-type Al_{0.2}Ga_{0.8}As/Al_{0.9}Ga_{0.1}As layers.

24. The method of Claim 18, wherein said cap layer (54) comprises p-type GaAs.

25. A semiconductor laser made by the method of Claim 16.

26. A method of reducing crystal defects in a semiconductor laser comprising limiting the amount of oxygen present in at least one layer of said semiconductor laser.

27. The method of Claim 26, wherein said limiting comprises:
growing a plurality of layers at a temperature of 700 degrees C;
injecting a source gas onto said semiconductor laser while growing a lower mirror (44), wherein a ratio of group V elements to group III elements in said source gas is about 80.

28. The method of Claim 26, further comprising:
injecting a second source gas onto said semiconductor laser while growing an upper mirror, wherein a second ratio of group V elements to group III elements in said second source gas is about 20.

29. A surface emission semiconductor laser device comprising:
a GaAs substrate (42); and
a layer structure formed on said GaAs substrate (42), said layer structure having a plurality of constituent layers including at least one active layer (48), a pair of cladding layers (46, 50) sandwiching therebetween said active layer (48), and p-type and n-type AlₓGa₁₋ₓAs multilayer mirrors (44, 52) sandwiching therebetween said cladding layers (46, 50) and said active layer (48), given x being 0≤ x≤ 1, at least one of said multilayer mirrors (44, 52) including a selectively-oxidized current confinement layer (56) for introducing current to said active layer,
at least one of said constituent layers having an oxygen density of about 1 × 10¹⁸ cm⁻³ or less.

30. The surface emission semiconductor laser device as defined in claim 29, wherein, said oxygen density is counted based on oxygen atoms including separate oxygen atoms and coupled oxygen atoms residing in oxygen compounds and oxygen complexes, if any, in said at least one of said constituent layers.

31. The surface emission semiconductor laser device as defined in claim 29, wherein said at least one of said constituent layers includes said active layer.

32. The surface emission semiconductor laser device as defined in claim 29, wherein said at least one of said constituent layers resides in an area of a resonant cavity corresponding to an equivalent cavity length.

33. The surface emission semiconductor laser device as defined in claim 29, wherein said at least one of said constituent layers constitutes said n-type multilayer mirror.

34. The surface emission semiconductor laser device as defined in claim 29, wherein said at least one of said constituent layers constitutes said p-type multilayer mirror.
